# EUROPEAN PATENT SPECIFICATION

(11) **EP 0 405 838 B1**
(45) Date of publication and mention of the grant of the patent: **22.03.1995**
(21) Application number: 90306780.9
(22) Date of filing: 21.06.1990
(51) Int. Cl.: H01R 23/70

(54) **Header device**
Halteranordnung
Système d'embase

(30) Priority: 30.06.1989 JP 76433/89 U
(43) Date of publication of application: 02.01.1991
(73) Proprietor: E.I. DU PONT DE NEMOURS AND COMPANY, Wilmington Delaware 19898 (US)
(72) Inventor: Hock, Lwee Nai, 08-50, Singapore 2365 (SG); Kuang, Kan Meng, 08-172, Singapore 2260 (SG)
(74) Representative: Barnard, Eric Edward

(56) References cited:
- WO-A-87/04041
- DE-U- 8 811 877
- GB-A- 1 413 737
- US-A- 3 315 217
- US-A- 4 750 889

## Description

The present invention relates to a connector attached to an end face of a printed circuit board and, in particular, the present invention relates to the structure of a connector in the form of a header device.

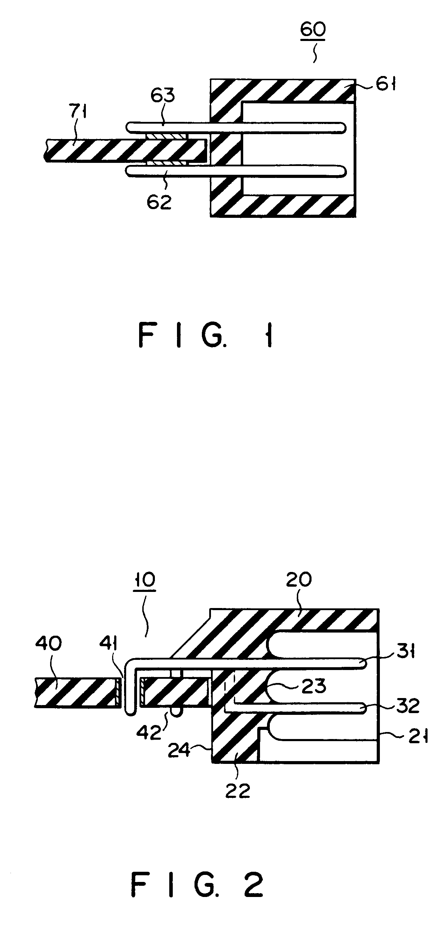

As a low-profile connector attached to an end face of a printed circuit board, an edge mounted type connector 60 is known which has a two-level pin array as shown in Fig.1. The edge-mounted type connector 60 includes straight pins 62 and 63 in a two-level array in a housing 61 made of plastics. The connector 60 is attached to a printed circuit board 71 by soldering the forward end portions of the pins 62 and 63 to the corresponding surfaces of the printed circuit board.

In the edge mounted type connector 60, the pins undergo an axial force upon the insertion and withdrawal of them into and out of a female connector and are liable to be separated from the printed circuit board at the soldered joints. Furthermore, since the pins are merely inserted into corresponding holes in the housing, they are liable to be loosened in the holes, or slipped out of the housing, upon repeated mating and unmating of the female connector.

DE-U-88 11 877.0 discloses a header device on a printed circuit board in which rows of contacts are set in a housing recess for receiving a female connector. The contacts are bent so that the forces produced when the female connector is repeatedly inserted and withdrawn do not act to separate the contacts. The contacts extend out through a wall portion of a housing disposed parallel to a printed circuit board and in spaced-apart rows.

It is accordingly an object of the present invention to provide a more compact header device whose contact pins are not easily separated from a printed circuit board and are prevented from slippage out of a housing.

As is known from DE-U-8811877.0, the invention provides a header device for mounting on a printed circuit board having through holes; said device comprising:
a housing of electrically insulating material, the housing having on one side a recess for receiving a mating connector and having on an opposite side a first wall section with an internal surface and an external surface adapted for mounting in confronting relationship to and adjacent an end face of the printed circuit board and a plurality of contact pins extending from the recess and through said first wall section of the housing; wherein first portions of said pins extend from the internal wall surface into the recess and are arranged in at least two parallel arrays perpendicular to and symmetrical with respect to the end face of the printed circuit board and wherein second portions of said pins are bent to provide end portions perpendicular to the printed circuit board and insertable into the through holes of the printed circuit board. In contrast to DE-U-88 11 877.0 and in accordance with the invention one outermost array of said arrays is in a plane near a top surface of the printed circuit board and another outermost array of said arrays is in a plane near a bottom surface of the printed circuit board, the second portions of all said pins extend through said first wall section of the housing and out from the external wall surface and the pins of at least one array are bent within the first wall section of the housing such that all the pins extend in a common plane out of the external surface of the first wall section of the housing.

Preferably the second portions of the pins extending in the common plane out of the external wall surface of the housing are also parallel to the printed circuit board and are then bent to provide the insertable end portions. Preferably the pins are encapsulated and moulded into the wall section of the housing.

A removable cover may be provided to prevent contamination of the pins during soldering.

In a preferred embodiment of the header device, the pins all extend horizontally at the same level out of the first wall section of the housing, and the end portions of the pins which are bent into a vertical hook-like form at different locations are inserted in the corresponding through-holes of the printed circuit board and soldered therein. As a result, even if a horizontal force is applied to the pins upon the insertion, and withdrawal of a mating female connector, the pins cannot be detached from the through-holes because of soldered connections and because of the latching of the vertically bent end portions of the pins in the through-holes. It is therefore possible for the device to withstand repeated connection and disconnection of the female connector.

This invention can be more fully understood from the following detailed description when taken in conjunction with the accompanying drawings, in which:
Figure 1 is a cross-section view showing a conventional edge mounted type connector;
Figure 2 is a cross-section view showing a header device according to one embodiment of the present invention;
Fig. 3 is a perspective view showing the header device of Fig. 2 and a cover;
Fig. 4 is a plan view showing the header device and the cover of Fig. 3,
Fig. 5 is a perspective view showing the header device and cover of Fig. 3 attached to a printed circuit board; and
Fig. 6 is a cross-sectional view showing the device of Fig. 5.

The present invention will now be explained below with reference to the accompanying drawings.

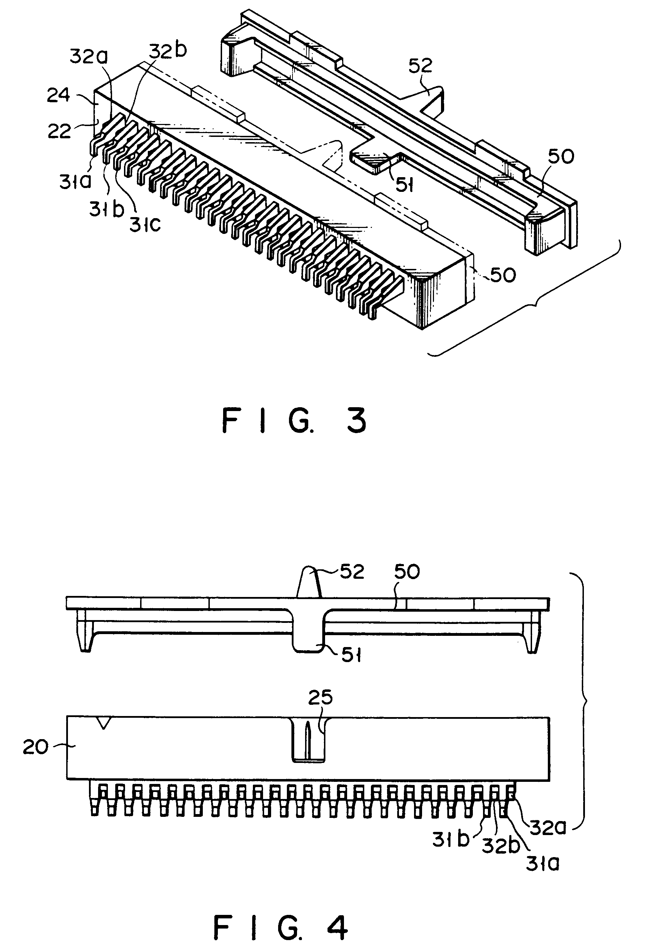

A header device 10 according to one embodiment of the present invention has an elongated-box type housing 20 as shown in Figs. 2 and 3. The housing is opened at one side 21 as shown in Fig. 2. The housing has a first section 22 located opposite to the open side 21. A plurality of conductive pins 31 (31a, 31b, 31c,...) and 32 (32a, 32b, 33c...) extend through and are fixed to a first section 22 of the housing. The header device 10 is attached to the end face of the printed circuit board 40 such that the first section 22 of the housing 20 faces the end face of the printed circuit board with the forward end portions of the pins 31 and 32 inserted into through-holes 41 and 42 of the printed circuit board 40.

The pins 31 and 32 are so arranged that they extend in the two-level array from the inner surface 23 of the first section 22 of the housing. The pins 31 at the upper level extend horizontally through the first section 22 and extend from the outer surface 24 of the first section 22. The pins 32 at the lower level is bent at three places in the first section 22 and extends out of the outer surface 24 of the first section 22 at the same level as that of the upper pins 31.

More specifically, referring to Fig. 2, the pin 32 extends from the inner surface 23 to the inside of the first section 22 (toward the left in the drawing) along the same straight line as the pin 32 extends from the inner surface 23 toward the right in the drawing. In the first section 22, the pin 32 bends substantially at a right angle toward the back of the plane of the drawing, and again bends substantially at a right angle and extends uprightly, as shown by the broken lines in the drawing, to the height at which the pin 31 extends horizontally. Then, the pin 32 extends horizontally at the same height as the pin 31 toward the outer surface 24 and protrudes outwardly from the outer surface 24.

The pins 31 and 32 horizontally extending from the surface 24 are bent substantially vertically so that the forward end portions thereof are inserted into through-holes 41 and 42 in the printed circuit board 40. The forward end portions of the pins 31 and 32 thus inserted into the through-holes can be respectively soldered thereon. As shown in Figs. 3 and 4, the pins 31 and 32 alternately extend horizontally out of the first section 22 and away from the outer surface 24 of the housing 20.

The present header device 10 can be manufactured by filling plastic material into a mold in which the pins 31 and 32 are positioned. The header device thus manufactured has their pins 31 and 32 encapsulated in and sealingly attached to the plastic housing 20.

Since the forward end portion of the pin is bent as a hook form, even if any horizontal force is applied to the pin upon the insertion and withdrawal of, for example, the female connector into and out of the header device, the pins can firmly be held relative to the printed circuit board due to a solder joint between the pins and the through-holes in the printed circuit board and the due to latch joint between forward end portions of the pins and the through-holes in the printed circuit board. Furthermore, as the pins are sealed to the housing, there is no possibility that, like the aforementioned conventional edge mounted type connector with pins merely inserted into the corresponding holes of the housing, the pins will be loosened in the holes of the housing or slipped out of the housing upon repeated insertion and withdrawal of a female connector into and out of the header device. The header device of the present invention can withstand multi-mating and unmating. Furthermore, since the pins at the upper and lower levels extend in the same plane, the header device of the present invention can achieve substantially the same height as the conventional edge mounted type connector.

In the present header device 10, as the material of which the housing 20 is made, use can preferably be made of high temperature plastics so that even if the pins 31 and 32 are jointed by, for example, a "wave soldering process" to the through-holes 41 and 42 they are not deformed by heat of a molten solder.

A cover 50 can be removably attached to the open side 21 of the housing 20. If, particularly, the wave soldering process employed for fully automated soldering process, the cover 50 can be used in which case neither a molten solder nor flux enters the housing to positively prevent a pin contamination. It is not possible to apply the wave soldering process to the conventional edge mounted type connector and it is necessary to perform a solder bond by a manual operation, so that an inconsistent quality solder joint is liable to be produced.

In the present header device 10, it is possible to automate a solder-bonding step, while using the cover 50, and to obtain a solder bond of stable quality and high reliability at a high productivity.

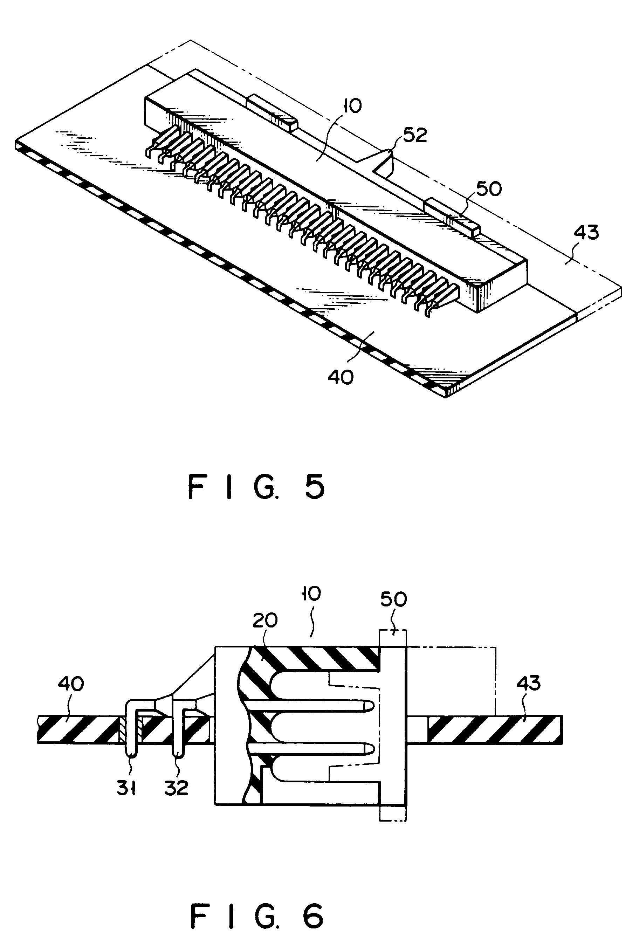

As shown in Fig. 4, a tab 51 can be formed on the cover 50 to conform to a polarizing slot 25 in the housing 20. The slot 25 is closed with the tab 51. If the tab 51 is formed as breakable tab which is readily removed away from the body of the cover 50, for example, by bending, a common cover can be used for either a housing with a polarizing slot or a housing without a polarizing slot. A supporting tab 52 can be formed on the outer side of the cover 50. As shown in Figs. 5 and 6, the supporting tab 52 is placed in contact with an auxiliary printed circuit board 43 as an extension of the printed circuit board 40 and stably supports the header device 10 on the printed circuit board 40 so as to prevent tilt of the header device 10 during a soldering process.

The header device 10 has been explained as one embodiment. The present invention is not restricted to the aforementioned embodiment in terms of the shape and array of pins. That is, so long as the pins extend inside the housing at the two-level array and outside the housing in the same plane, any pins of arbitrary shape can be employed and upper and lower pins can have the same shape.

As set forth above, in the present invention, it is achieved, to prevent a ready slippage of pins both out of the housing and out of the printed circuit board even upon the repeated insertion and withdrawal of connector such as a female connector. This can be achieved by sealingly fixing the pins to the housing and bending forward end portions of the pins, which extend out of the housing, substantially vertically so as to be inserted into the corresponding through-holes of the printed circuit board and soldered thereto.

## Claims

1. A header device (10) for mounting on a printed circuit board (40) having through holes (41,42); said device comprising:
a housing (20) of electrically insulating material, the housing (20) having on one side a recess (21) for receiving a mating connector and having on an opposite side a first wall section (22) with an internal surface (23) and an external surface (24) adapted for mounting in confronting relationship to and adjacent an end face of the printed circuit board (40) and a plurality of contact pins (31,32) extending from the recess (21) and through said first wall section (22) of the housing (20); wherein first portions of said pins (31,32) extend from the internal wall surface (23) into the recess (21) and are arranged in at least two parallel arrays perpendicular to and symmetrical with respect to the end face of the printed circuit board (40) and wherein second portions of said pins are bent to provide end portions perpendicular to the printed circuit board (40) and insertable into the through holes (41,42) of the printed circuit board (40); characterised in that one outermost array of said arrays is in a plane near a top surface of the printed circuit board and another outermost array of said arrays is in a plane near a bottom surface of the printed circuit board, the second portions of all said pins extend through said first wall section (22) of the housing (20) and out from the external wall surface (24) and the pins (31,32) of at least one array are bent within the first wall section (22) of the housing (20) such that all the pins (31,32) extend in a common plane out of the external surface (24) of the first wall section (22) of the housing (20).

2. A device according to claim 1 wherein the pins (31,32) lying in the common plane extending out of the external surface (24) of the first wall section (22) are disposed parallel to the printed circuit board (40).

3. A device according to claim 1 or 2 wherein the pins (31,32) are encapsulated and moulded in the wall section of the housing (20).

4. A device according to claim 1, 2 or 3 wherein the recess (21) is closable with a removable cover (50).

5. A device according to claim 4 wherein the cover (50) and the housing (20) are provided with an interengageable slot (25) and tab (51).

6. A device according to claim 5, wherein the tab (51) is breakable or easily bent.

7. A device according to any one of claims 4 to 6 wherein a further tab (52) projects outwardly from the cover (50) and serves to stabilise the device by contacting an auxiliary circuit board substrate while supporting the housing (20) and thereby prevent tilting of the device during soldering.

## Patentansprüche

1. Verteilervorrichtung (10) zur Befestigung auf einer gedruckten Leiterplatte (40) mit durchgehenden Öffnungen (41,42), wobei die Vorrichtung folgendes aufweist:
ein Gehäuse (20) aus einem elektrisch isolierenden Material, wobei das Gehäuse (20) auf einer Seite eine Ausnehmung (21) zum Aufnehmen eines dazu passenden Steckers besitzt und das Gehäuse auf einer gegenüberliegenden Seite einen ersten Wandabschnitt (22) mit einer Innenfläche (23) und einer Außenfläche (24) aufweist, die dafür geeignet sind, um sie in Gegenüberlage zu und dicht bei einer Endfläche der gedruckten Leiterplatte (40) zu montieren und wobei sich eine Vielzahl von Kontaktstiften (31, 32) von der Ausnehmung (21) heraus und durch den ersten Wandabschnitt (22) des Gehäuses (20) hindurch erstrecken; wobei ferner erste Abschnitte der Stifte (31, 32) sich von der Innenwandfläche (23) in die Ausnehmung (21) hinein erstrecken und in wenigstens zwei parallelen Anordnungen senkrecht zu und symmetrisch in bezug auf die Endfläche der gedruckten Leiterplatte (40) angeordnet sind und wobei zweite Abschnitte der Stifte so gebogen sind, um Endabschnitte zu schaffen, die senkrecht zu der gedruckten Leiterplatte (40) verlaufen und in die durchgehenden Öffnungen (41, 42) der gedruckten Leiterplatte (40) einschiebbar sind, dadurch **gekennzeichnet**, daß eine am weitesten außen gelegene Anordnung der Anordnungen in einer Ebene nahe der oberen Fläche der gedruckten Leiterplatte liegt und eine andere am weitesten außen liegende Anordnung der Anordnungen in einer Ebene nahe einer Bodenfläche der gedruckten Leiterplatte gelegen ist, wobei sich die zweiten Abschnitte aller Stifte durch den ersten Wandabschnitt (22) des Gehäuses (20) erstrecken und sich von der Außenwandfläche (24) nach außen erstrecken und wobei die Stifte (31, 32) von wenigstens einer Anordnung innerhalb des ersten Wandabschnitts (22) des Gehäuses (20) derart umgebogen sind, daß alle Stifte (31, 32) sich in einer gemeinsamen Ebene von der Außenfläche (24) des ersten Wandabschnitts (22) des Gehäuses (20) nach außen erstrecken.

2. Vorrichtung nach Anspruch 1, bei der die Stifte (31, 32), die in der gemeinsamen Ebene liegen und sich von der Außenfläche (24) des ersten Wandabschnitts (22) nach außen erstrecken, parallel zu der gedruckten Leiterplatte (40) angeordnet sind.

3. Vorrichtung nach Anspruch 1 oder 2, bei der die Stifte (31, 32) in dem Wandabschnitt des Gehäuses (20) eingekapselt und eingegossen sind.

4. Vorrichtung nach Anspruch 1, 2 oder 3, bei der die Ausnehmung (21) mit einer entfernbaren Abdeckung (50) verschließbar ist.

5. Vorrichtung nach Anspruch 4, bei der die Abdeckung (50) und das Gehäuse (20) mit einer Fahne (51) und Schlitz (25), die ineinandergreifen, ausgestattet sind.

6. Vorrichtung nach Anspruch 5, bei der die Fahne (51) abbrechbar oder leicht verbiegbar ausgebildet ist.

7. Vorrichtung nach irgendeinem der Ansprüche 4 bis 6, bei der eine weitere Fahne (52) von der Abdeckung (50) nach außen ragt und dazu dient, die Vorrichtung durch Berühren eines Hilfs-Leiterplattensubstrats zu stabilisieren und das Gehäuse (20) zu haltern und dadurch ein Neigen der Vorrichtung während des Lötvorganges zu verhindern.

## Revendications

1. Un dispositif d'embase (10) adaptable sur une carte de circuit imprimé (40) comprenant des trous traversants (41, 42); ledit dispositif comprenant:
un boîtier (20) en matériau isolant électrique, le boîtier (20) étant pourvu sur l'un des côtés d'une cavité (21) prévue pour recevoir un connecteur complémentaire et comprenant, sur un côté opposé, une première partie de paroi (22) munie d'une surface intérieure (23) et d'une surface extérieure (24), agencée pour être fixée en opposition et adjacente à une face d'extrémité de la carte de circuit imprimé (40), et une pluralité de broches de contact (31, 32) s'étendant à partir de la cavité (21) et traversant ladite première partie de paroi (22) du boîtier (20); dans lequel les premières parties desdites broches (31, 32) se prolongent, à partir de la surface de paroi interne (23), à l'intérieur de la cavité (21) et sont disposées en, au moins, deux rangées parallèles, perpendiculaires et symétriques par rapport à la face d'extrémité de la carte de circuit imprimé (40), et dans lequel des secondes parties desdites broches sont repliées pour former des parties d'extrémité perpendiculaires à la carte de circuit imprimé (40) et susceptibles d'être introduites dans les trous traversants (41, 42) de la carte de circuit imprimé (40); caractérisé en ce qu'une rangée extérieure desdites rangées est dans un plan voisin d'une surface supérieure de la carte de circuit imprimé et qu'une autre rangée extérieure desdites rangées est dans un plan voisin de la surface de fond de la carte de circuit imprimé, les secondes parties de toutes lesdites broches se prolongeant à travers ladite première partie de paroi (22) du boîtier (20) et au dehors de la surface de paroi extérieure (24), et les broches (31, 32) d'au moins une rangée sont repliées ou incurvées dans la première partie de paroi (22) du boîtier (20) de manière que toutes les broches (31, 32) s'étendent dans un plan commun, hors de la surface extérieure (24) de la première partie de paroi (22) du boîtier (20).

2. Un dispositif selon la revendication 1, dans lequel les broches (31, 32) situées dans le plan commun s'étendant à partir de la surface extérieure (24) de la première partie de paroi (22) sont disposées parallèlement à la carte de circuit imprimé (40).

3. Un dispositif selon la revendication 1 ou 2, dans lequel les broches (31, 32) sont enrobées et moulées dans la partie de paroi du boîtier (20).

4. Un dispositif selon la revendication 1, 2 ou 3, dans lequel la cavité (21) peut être fermée par un couvercle amovible (50).

5. Un dispositif selon la revendication 4 dans lequel le couvercle (50) et le boîtier (20) sont pourvus d'une fente (25) et d'une languette (51) s'engageant mutuellement.

6. Un dispositif selon la revendication 5, dans lequel la languette (51) peut être rompue ou facilement pliée.

7. Un dispositif selon l'une quelconque des revendications 4 à 6, dans lequel une autre languette (52) est en saillie vers l'extérieur à partir du couvercle (50) et sert à stabiliser le dispositif par contact avec un support de carte de circuit imprimé auxiliaire tout en supportant le boîtier (20) , et de manière à empêcher ainsi le basculement du dispositif pendant le soudage.
